(19) **Europäisches Patentamt**
**European Patent Office**
**Office européen des brevets**

(11) **EP 2 643 857 B1**

(12) **EUROPEAN PATENT SPECIFICATION**

(45) Date of publication and mention
of the grant of the patent:
**06.03.2019 Bulletin 2019/10**

(51) Int Cl.:
*H01L 31/09* [(2006.01)]     *G01J 1/02* [(2006.01)]
*H01L 51/46* [(2006.01)]

(21) Application number: **11843638.5**

(86) International application number:
**PCT/US2011/056180**

(22) Date of filing: **13.10.2011**

(87) International publication number:
**WO 2012/071116 (31.05.2012 Gazette 2012/22)**

(54) **IR PHOTODETECTORS WITH HIGH DETECTIVITY AT LOW DRIVE VOLTAGE**

IR-PHOTODETEKTOREN MIT HOHER ERKENNUNGSKAPAZITÄT BEI NIEDRIGER
STEUERSPANNUNG

PHOTODÉTECTEURS IR PRÉSENTANT UNE DÉTECTIVITÉ ÉLEVÉE À BASSE TENSION
D'EXCITATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.11.2010 US 416630 P**

(43) Date of publication of application:
**02.10.2013 Bulletin 2013/40**

(73) Proprietors:
• **University of Florida Research Foundation, Inc.
Gainesville, FL 32611 (US)**
• **Nanoholdings, LLC
Rowayton, CT 06853 (US)**

(72) Inventors:
• **SO, Franky
Cary,
NC 27518 (US)**
• **KIM, Do Young
Tulsa,
OK 74137 (US)**
• **SARASQUETA, Galileo
Gilbert,
AZ 85297 (US)**

• **PRADHAN, Bhabendra, K.
Marietta
GA 30066 (US)**

(74) Representative: **Gill Jennings & Every LLP
The Broadgate Tower
20 Primrose Street
London EC2A 2ES (GB)**

(56) References cited:
**WO-A2-2006/130717        WO-A2-2008/042859
WO-A2-2010/120393        US-A1- 2006 024 526
US-A1- 2007 176 541        US-A1- 2008 223 445
US-A1- 2009 206 745        US-A1- 2009 286 338
US-A1- 2010 141 122**

• **IM S H ET AL: "Near-infrared photodetection
based on PbS colloidal quantum dots/organic
hole conductor", ORGANIC ELECTRONICS,
ELSEVIER, AMSTERDAM, NL, vol. 11, no. 4, 1
April 2010 (2010-04-01), pages 696-699,
XP026933282, ISSN: 1566-1199, DOI:
10.1016/J.ORGEL.2009.12.021 [retrieved on
2010-01-04]**

EP 2 643 857 B1

**Description**

BACKGROUND OF INVENTION

Existing night vision goggles are complex electro-optical devices that intensify existing light instead of relying on their own light source. In a typical configuration, a conventional lens, called the objective lens, captures ambient light and some near-infrared light. The gathered light is then sent to an image-intensifier tube. The image-intensifier tube uses a photo cathode to collect photons of light energy for the generation of electrons. As the electrons pass through the tube, more electrons can be released from atoms in the tube, multiplying the original number of electrons by a factor of thousands, often accomplished using a micro channel plate (MCP). The image-intensifier tube can be positioned such that a cascade of electrons hits a screen coated with phosphors at the end of the tube with the electrons retaining the position of the channel through which they passed. The energy of the electrons causes the phosphors to reach an excited state and release photons, which create a green image on the screen and characterize state of the art night vision. The green phosphor image can be viewed through an ocular lens where the image is magnified and focused.

Recently, light up-conversion devices have attracted a great deal of research interest because of their potential applications in night vision, range finding, security, and semiconductor wafer inspections. Early near infrared (NIR) up-conversion devices were mostly based on the heterojunction structure of inorganic semiconductors, where a photodetecting and a luminescent section are in series. The up-conversion devices are mainly distinguished by the method of photodetection. Currently inorganic and hybrid up-conversion devices are expensive to fabricate and the processes used for fabricating these devices are not compatible with large area applications. Efforts are being made to achieve low cost up-conversion devices that have higher conversion efficiencies. Unfortunately, none have been identified to allow sufficient detectivity at low drive voltages, generally because of a high dark current density that leads to insufficient contrast in the photodetector. Hence, there remains a need to achieve high contrast in an up-conversion device and an IR photodetector with high detectivity while requiring low drive voltages, for example, about 10V.

WO2010/120393 A2 (UNIV MICHIGAN) 21 October 2010 (2010-10-21) discloses background information.

WO 2006/130717 A2 (UNIV CALIFORNIA [US]; YANG YANG [US]; SHAO YAN [US]) 7 December 2006 (2006-12-07) discloses background information.

IM S H ET AL: "Near-infrared photodetection based on PbS colloidal quantum dots/organic hole conductor", ORGANIC ELECTRONICS, ELSEVIER, AMSTERDAM, NL, vol. 11, no. 4, 1 April 2010 (2010-04-01), pages 696-699, XP026933282, ISSN: 1566-1199, DOI: 10.1016/J.ORGEL.2009.12.021 [retrieved on 2010-01-04] discloses background information.

US 2008/223445 A1 (MARKS TOBIN J [US] ET AL) 18 September 2008 (2008-09-18) discloses background information.

WO2008042859 A2 discloses background information.

BRIEF SUMMARY

According to a first aspect of the invention, there is provided an IR photodetector as set out in the claims.

According to a second aspect of the invention, there is provided a method as set out in the claims.

Embodiments of the invention are directed to infrared (IR) photodetectors comprising an IR sensitizing layer separating an electron blocking layer (EBL) and a hole blocking layer (HBL), wherein the IR photodetector has high detectivity. The IR photodetectors can be used at voltages below 20V. IR sensitizing layer comprises PbSe quantum dots (QDs), or PbS QD. The EBL can be poly(9,9-dioctyl-fluorene-*co*-N-(4-butylphenyl)diphenylamine) (TFB), Poly-*N*,*N*-bis-4-butylphenyl-*N*,*N*-bis-phenylbenzidine (poly-TPD), or polystyrene-N,N-diphenyl-N,N-bis(4-n-butylphenyl)-(1,10-biphenyl)-4,4-diamine-perfluorocyclobutane (PS-TPD-PFCB) and the HBL comprises nanoparticles.

BRIEF DESCRIPTION OF DRAWINGS

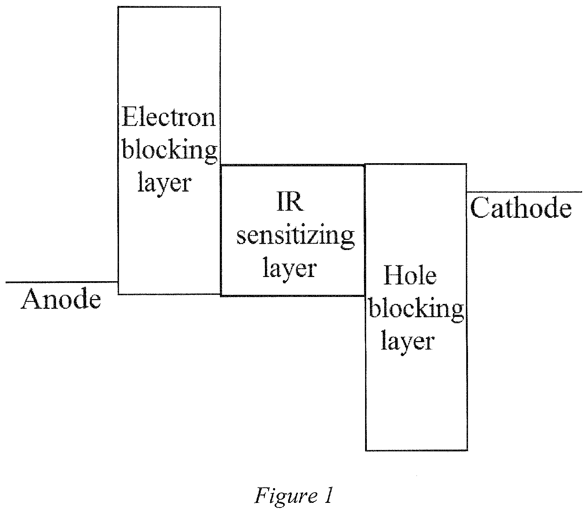

Figure 1 shows a schematic for an infrared photodetector with high detectivity according to an embodiment of the invention.

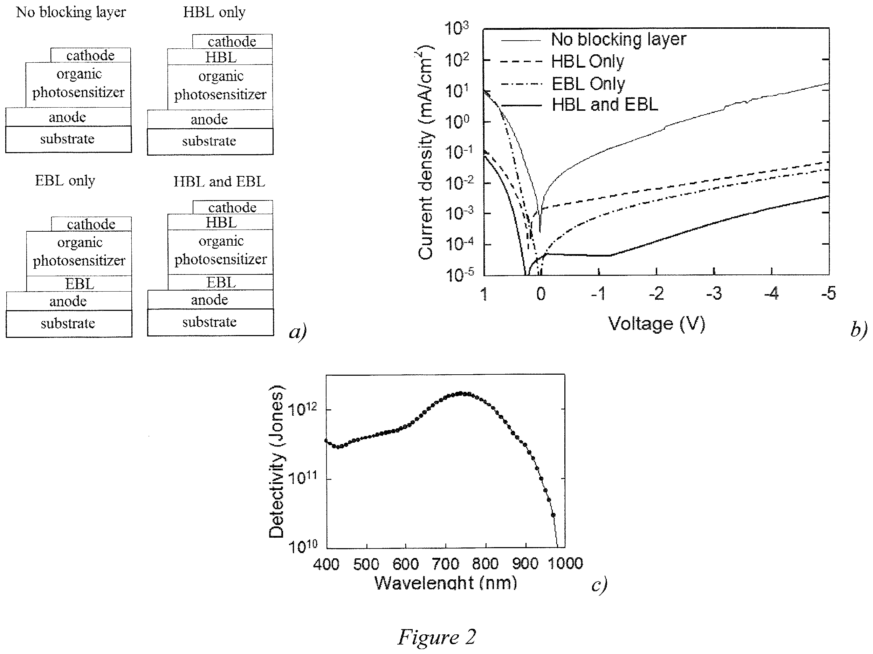

Figure 2 shows a) a schematic diagram and b) dark J-V characteristics of organic photodetector without and with a hole blocking layer and/or an electron blocking layer, and (c) detectivity of an organic photodetector with both hole and electron blocking layer as a function of wavelength, according to an embodiment of the invention.

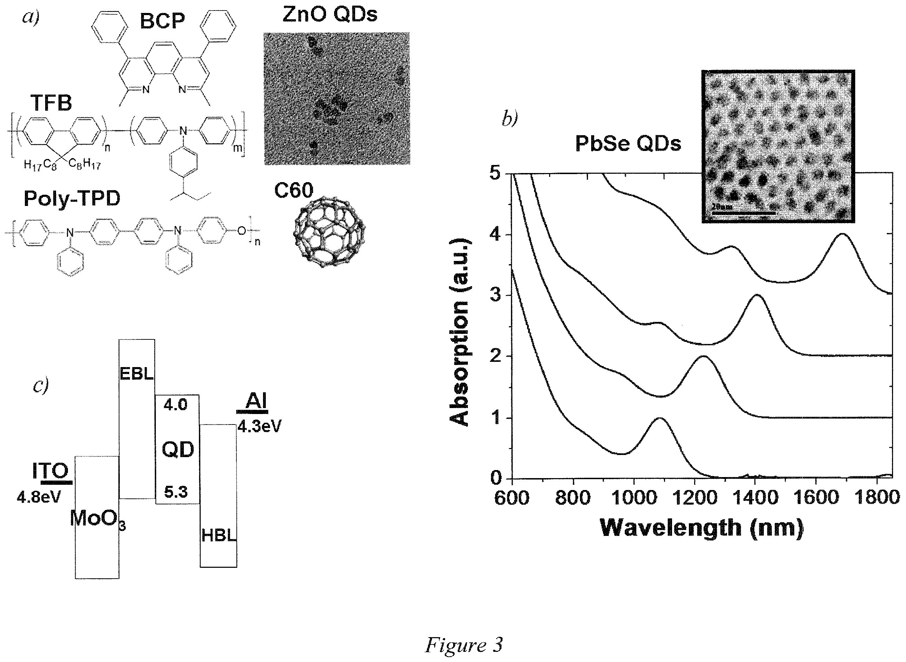

Figure 3 shows a) the chemical structures of EBL and HBL materials and a TEM image of the IR sensitizing material used to prepare IR photodetectors, according to an embodiment of the invention, b) typical absorption spectra of various sized PbSe QD nanocrystals with an insert of a TEM image of the quantum dots, and c) a schematic of an energetic structure for an IR photodetector with a reduced dark current.

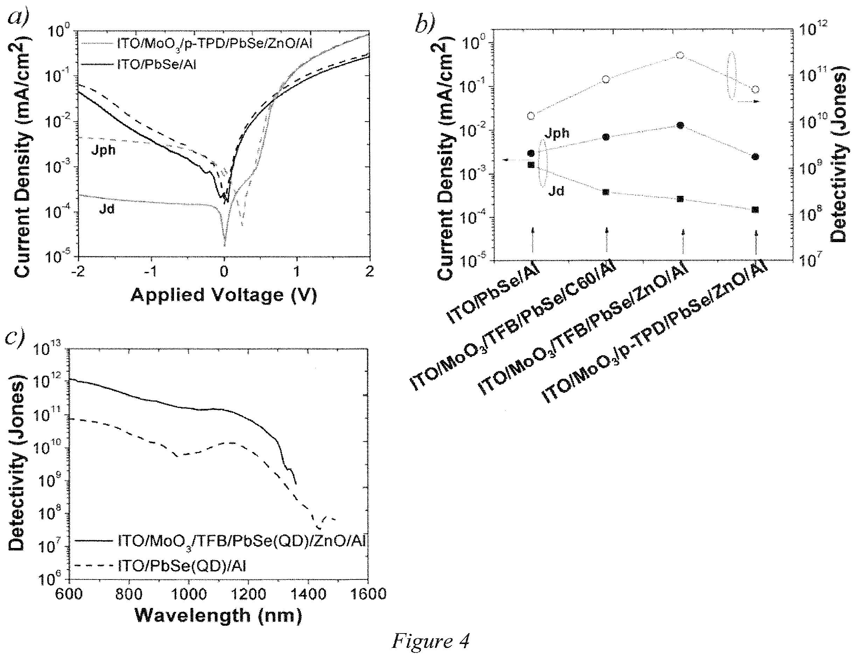

Figure 4 shows a) a plot of the current-voltage (J-V) characteristics of PbSe quantum dot comprising photodetectors without and with an HBL and an EBL, according to an embodiment of the invention, in a dark ($J_d$) and an illumination ($J_{ph}$) state upon irradiation at $\lambda$= 830nm, b) the dark currents, photo-currents, and calculated detectivity values for various IR photodetectors under a -0.5V bias, and c) detectivity curves across the visible and IR spectrum for photodetectors without and with an HBL and an EBL calculated from spectral response curves biased at -0.5V.

## DETAILED DISCLOSURE

Embodiments of the invention are directed to an infrared photodetector with high detectivity for use as a sensor and for use in an up-conversion device. When the dark current is the dominant noise factor, detectivity can be expressed as the following equation (1).

$$D* = R/(2qJ_d)^{1/2} \qquad (1)$$

where R is the responsivity, $J_d$ is the dark current density, and $q$ is the elementary charge (1.6 x $10^{-19}$ C). To achieve a photodetector with an optimal detectivity, a very low dark current density is required. The photodetectors, according to embodiments of the invention, comprise a hole blocking layer (HBL) with a deep highest occupied molecule orbital (HOMO) and an electron blocking layer (EBL) with a high lowest unoccupied molecule orbital (LUMO), where the EBL is situated on the anode facing surface and the HBL is situated on the cathode facing surface of an IR photosensitive layer, as shown in Figure 1. The layers can range from about 20 nm to about 500 nm in thickness, and where the overall spacing between electrodes is less than 5 $\mu$m. The IR photodetector, according to embodiments of the invention, allows high detectivity at applied voltages less than 5V.

In embodiments of the invention, the IR photosensitive layer comprises a material according to the claims. In some embodiments of the invention, the material absorbs through a large portion of the IR, extending beyond the near IR (700 to 1400 nm), for example, to wavelengths up to 1800 nm or greater. Exemplary organic or organometallic comprising materials include: perylene-3,4,9,10-tetracarboxylic-3,4,9,10-dianhydride (PCTDA); tin (II) phthalocyanine (SnPc); SnPc:$C_{60}$; aluminum phthalocyanine chloride (AlPcCl); AlPcCl:$C_{60}$; titanyl phthalocyanine (TiOPc); and TiOPc:$C_{60}$. Inorganic materials for use as photosensitive layers include: PbSe quantum dots (QDs); PbS QDs.

In embodiments of the invention, the HBL comprises an inorganic material including, thin films or nanoparticles of ZnO.

In embodiments of the invention, the EBL can be an organic material, including, but not limited to: poly(9,9-dioctyl-fluorene-*co*-N-(4-butylphenyl)diphenylamine) (TFB); 1,1-bis[(di-4-tolylamino)phenyl]cyclohexane (TAPC); *N,N'*-diphenyl-*N,N'*(2-naphthyl)-(1,1'-phenyl)-4,4'-diamine (NPB); *N,N'*-diphenyl-*N,N'*-di(m-tolyl) benzidine (TPD); poly-*N,N'*-bis-4-butylphenyl-*N,N'*-bis-phenylbenzidine (poly-TPD); or polystyrene-*N,N*-diphenyl-*N,N*-bis(4-*n*-butylphenyl)-(1,10-biphenyl)-4,4-diamine-perfluorocyclobutane (PS-TPD-PFCB).

## METHODS AND MATERIALS

Photodetectors were prepared having no blocking layer, poly-TPD as an EBL, ZnO nanoparticles as a HBL, and with poly-TPD and ZnO nanoparticles as an EBL and a HBL, respectively, as shown in Figure 2a, where the IR photosensitive layer comprised PbSe nanocrystals. As can be seen in Figure 2b, the dark current-voltage (J-V) plots for the photodetectors decreased by more than 3 orders of magnitude from that with an EBL and a HBL from the photodetector that is blocking layer free. The photodetector with both blocking layers shows a detectivity of more than $10^{11}$ Jones over IR and visible wavelengths smaller than 950 nm.

Inorganic nanoparticle photodetectors were also constructed having no blocking layers and with EBL and HBL layers. The photodetector, as schematically illustrated in Figure 3c, comprised various HBLs (BCP, C60, or ZnO), EBLs (TFB or poly-TPD), whose structures are shown in Figure 3a, and where PbSe quantum dots comprised the IR photosensitive layer, which is shown in Figure 3b as a TEM image as an insert to the layers' IR absorption spectrum. The photodetectors comprising BCP and C60 as HBL and without blocking layers do not form part of the present invention. The HOMO and LUMO levels of these blocking materials are given in Table 1, below. Although the magnitude of reduction differs, placement of an EBL and a HBL on the PbSe comprising photodetector results in a significant reduction of the dark current at low applied voltages, as shown in Figure 4a. Figure 4b is a plot of the dark current, photo current, and detectivity of the PbSe comprising photodetector without and with the various blocking layer systems. Figure 4c shows the enhancement in the detectivity as a function of wavelength that results by having an EBL and a HBL.

Table 1 Blocking Layer Materials and their HOMO and LUMO Energies

| Material | HOMO Energy in eV | LUMO Energy in eV | Type of Layer |
|---|---|---|---|
| TFB | -5.3 | -2.1 | Electron Blocking |
| Poly-TPD | -5.1 | -2.3 | Electron Blocking |
| $C_{60}$ | -6.2 | -4.3 | Hole Blocking |
| BCP | -6.5 | -1.9 | Exciton/Hole Blocking |
| ZnO (NC) | -7.6 | -4.2 | Hole Blocking |

## Claims

1. An IR photodetector, comprising an IR sensitizing layer comprising PbS quantum dots and/or PbSe quantum dots separating an electron blocking layer (EBL) and a hole blocking layer (HBL), wherein the IR photodetector has high detectivity, and wherein the HBL comprises a film of ZnO nanoparticles.

2. The IR photodetector of claim 1, wherein the EBL comprises poly(9,9-dioctyl-fluorene-*co*-N-(4-butylphenyl)diphenylamine) (TFB), Poly-*N*,*N-bis*-4-butylphenyl-*N*,*N-bis*-phenylbenzidine (poly-TPD), or polystyrene-N,N-diphenyl-N,N-bis(4-n-butylphenyl)-(1,10-biphenyl)-4,4-diamine-perfluorocyclobutane (PS-TPD-PFCB).

3. The IR photodetector of claim 1, further comprising an anode and a cathode, wherein the EBL is positioned between the anode and the IR-sensitizing layer, wherein the HBL is positioned between the cathode and the IR-sensitizing layer.

4. A method of using an IR photodetector according to claim 1, wherein the IR photodetector has a detectivity of at least $10^{11}$ Jones, the method comprising:

    applying a reverse bias voltage of 20 V or less to the photodetector;
    exposing the photodetector to near-infrared and/or infrared radiation; and
    measuring a current from the photodetector.

5. The method of claim 4, wherein the step of applying a reverse bias voltage comprises applying a reverse bias voltage of 5 V or less to the photodetector.

## Patentansprüche

1. IR-Photodetektor, umfassend eine IR-Sensibilisierungsschicht, umfassend PbS-Quantenpunkte und/oder PbSe-Quantenpunkte, die eine Elektronenblockierschicht (EBL) und eine Lochblockierschicht (HBL) trennen, wobei der IR-Photodetektor eine hohe Detektivität aufweist, und wobei die HBL einen Film aus ZnO-Nanopartikeln umfasst.

2. IR-Photodetektor nach Anspruch 1, wobei die EBL Poly(9,9-dioctyl-Fluoren-co-N-(4-butylphenyl)diphenylamin) (TFB), Poly-*N*,*N-bis*-4-butylphenyl-*N*,*N-bis*-phenylbenzidin (Poly-TPD) oder Polystyrol-N,N-Diphenyl-N,N-bis(4-n-butylphenyl)-(1,10-biphenyl)-4,4-diaminperfluorcyclobutan (PS-TPD-PFCB) umfasst.

3. IR-Photodetektor nach Anspruch 1, ferner umfassend eine Anode und eine Kathode, wobei die EBL zwischen der Anode und der IR-Sensibilisierungsschicht angeordnet ist, wobei die HBL zwischen der Kathode und der IR-Sensibilisierungsschicht angeordnet ist.

4. Verfahren zur Verwendung eines IR-Photodetektors nach Anspruch 1, wobei der IR-Photodetektor eine Detektivität von mindestens $10^{11}$ Jones aufweist, wobei das Verfahren Folgendes umfasst:

    Anlegen einer umgekehrten Vorspannung von 20 V oder weniger an den Photodetektor;
    Belichten des Photodetektors mit einer dem Infrarotbereich nahen Strahlung und/oder mit Infrarotstrahlung; und
    Messen einer Spannung vom Photodetektor.

**5.** Verfahren nach Anspruch 4, wobei der Schritt des Anlegens einer umgekehrten Vorspannung das Anlegen einer umgekehrten Vorspannung von 5 V oder weniger an den Photodetektor umfasst.

## Revendications

**1.** Photodétecteur IR, comprenant une couche de sensibilisation aux IR comprenant des boîtes quantiques en PbS et/ou des boîtes quantiques en PbSe séparant une couche de blocage d'électrons (EBL) et une couche de blocage de trou (HBL), dans lequel le photodétecteur IR a une détectivité élevée, et dans lequel la HBL comprend un film de nanoparticules de ZnO.

**2.** Photodétecteur IR selon la revendication 1, dans lequel l'EBL comprend de la poly(9,9-dioctyl-fluorène-*co*-N-(4-butylphényl)diphénylamine) (TFB), de la poly-*N*,*N-bis*-4-butylphényl-*N*,*N-bis*-phénylbenzidine (poly-TPD), ou du polystyrène-N,N-diphényl-N,N-bis(4-n-butylphényl)-(1,10-biphényl)-4,4-diamine-perfluorocyclobutane (PS-TPD-PFCB).

**3.** Photodétecteur IR selon la revendication 1, comprenant en outre une anode et une cathode, dans lequel l'EBL est positionnée entre l'anode et la couche de sensibilisation aux IR, dans lequel la HBL est positionnée entre la cathode et la couche de sensibilisation aux IR.

**4.** Procédé d'utilisation d'un photodétecteur IR selon la revendication 1, dans lequel le photodétecteur IR a une détectivité d'au moins $10^{11}$ Jones, le procédé comprenant :

l'application d'une tension de polarisation inverse de 20 V ou moins au photodétecteur ;
l'exposition du photodétecteur à un rayonnement infrarouge et/ou proche infrarouge ; et
la mesure d'un courant depuis le photodétecteur.

**5.** Procédé selon la revendication 4, dans lequel l'étape d'application d'une tension de polarisation inverse comprend l'application d'une tension de polarisation inverse de 5 V ou moins au photodétecteur.

Figure 1

Figure 2

*Figure 3*

EP 2 643 857 B1

*Figure 4*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2010120393 A2
- WO 2006130717 A2
- US 2008223445 A1, MARKS TOBIN J
- WO 2008042859 A2

### Non-patent literature cited in the description

- Near-infrared photodetection based on PbS colloidal quantum dots/organic hole conductor. **IM S H et al.** ORGANIC ELECTRONICS. ELSEVIER, 01 April 2010, vol. 11, 696-699